Europäisches Patentamt

(19) European Patent Office

Office européen des brevets

(11) Publication number: **0 301 839 B1**

(12) **EUROPEAN PATENT SPECIFICATION**

(45) Date of publication of patent specification:
27.11.91 Bulletin 91/48

(51) Int. Cl.⁵: **H03J 5/24**

(21) Application number: 88306932.0

(22) Date of filing: 27.07.88

(54) Low noise converter.

(30) Priority: 27.07.87 JP 115479/87

(43) Date of publication of application:
01.02.89 Bulletin 89/05

(45) Publication of the grant of the patent:
27.11.91 Bulletin 91/48

(84) Designated Contracting States:
DE FR GB

(56) References cited:
US-A- 3 755 743
US-A- 4 180 804

(56) References cited:
INTERNATIONAL JOURNAL OF ELEC-
TRONICS, vol. 61, no. 4, October 1986, pages
539-542, London, GB; M.S.JAMIL-LASGHAR et
al.: "A solid-state relay for transformer switch-
ing"

(73) Proprietor: SHARP KABUSHIKI KAISHA
22-22 Nagaike-cho Abeno-ku
Osaka 545 (JP)

(72) Inventor: Noboru, Mitsuhiro
4-2-9, Nagao-cho
Sakai-shi Osaka-fu (JP)

(74) Representative: Brown, Kenneth Richard et al
R.G.C. Jenkins & Co. 26 Caxton Street
London SW1H 0RJ (GB)

## Description

### BACKGROUND OF THE INVENTION

The present invention relates to a low noise converter (Low Noise Block Downconverter : hereinafter "LNB") for receiving at least two frequency bands, and more particularly, to a construction of an LNB for switching between reception bands in accordance with a power-supply voltage level.

Conventionally, as is shown in Fig. 2, a power-supply voltage fed through an IF output terminal is fetched by a coil L. The fetched power-supply voltage is divided by resistors R1 and R2, and is compared with a reference voltage by a comparator 2. The reference voltage is provided through a voltage stabilizer from the power-supply voltage.

When an output of the comparator 2 is higher than the reference voltage and higher than a threshold voltage of a transistor TR, the transistor TR is switched on. By this, a relay 3 as a switch relay means is operated to switch a frequency band to receive. R3 is a resistor to cause hysteresis characteristics. D is a diode to protect the transistor TR. C is a condenser to cut a direct current. And, output of a three-terminal regulator 4 is supplied to each circuit inside the LNB.

However, with the above conventional circuit, the relay 3 is operated when the power-supply voltage is high, which causes increase of power consumption and further causes temperature rise inside the LNB.

### SUMMARY OF THE INVENTION

Accordingly, it is an aim of the present invention to provide an LNB which alleviates some of the aforementioned problems.

Briefly described, in accordance with the present invention, a low noise converter is provided for receiving a plurality of frequency bands and having switch means for switching between said bands in accordance with the level of a power supply voltage fed through an IF output terminal, wherein said switch means when energised consumes power derived from said power supply voltage, and wherein control means is provided for controlling the energisation of said switch means in accordance with said power supply voltage level, characterised in that said control means is so arranged that said switch means is energised when the power supply voltage is below a reference voltage level.

### BRIEF DESCRIPTION OF THE DRAWINGS

The present invention will become more fully understood from the detailed description given hereinbelow and the accompanying drawings which are given by way of illustration only, and thus are not limitative of the present invention and wherein :

FIG. 1 is a circuit diagram which shows an embodiment of the present invention ; and
FIG. 2 is a circuit diagram showing a conventional example.

### DESCRIPTION OF THE PREFERRED EMBODIMENTS

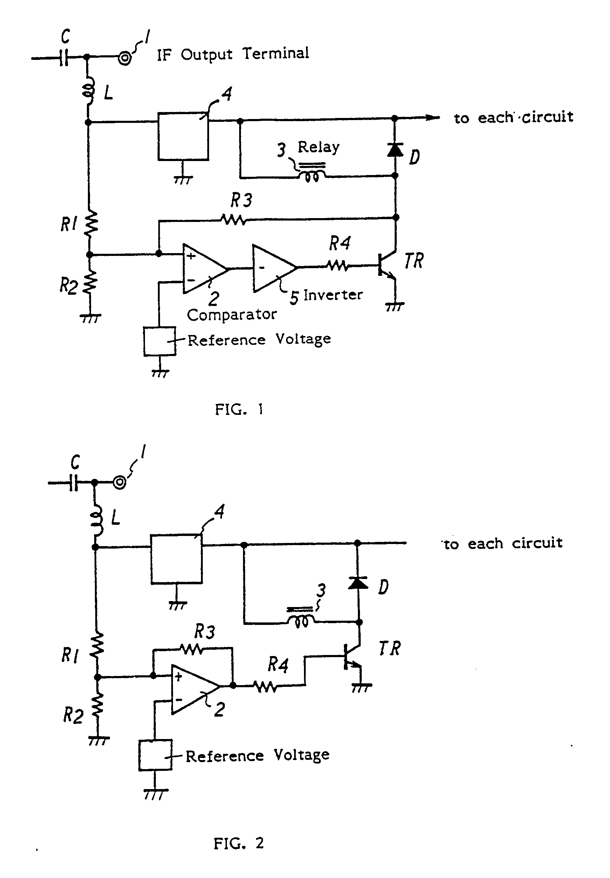

Like reference characters in FIG. 1 designate corresponding parts to that in FIG. 2.

FIG. 1 is a circuit diagram showing an embodiment of the present invention. A comparator 2 compares a power-supply voltage with a reference voltage. The output of the comparator 2 is first inverted by an inverter 5. When the output of the inverter 5 is higher than a threshold voltage, a transistor TR is switched on and a relay 3 is operated.

As is described above, the relay 3 is operated when the power-supply voltage is low, thus the current becomes increased. However, as the power-supply voltage is low, the power consumption (product of current and power-supply voltage) is reduced. Consequently, temperature rise inside the 2-band LNB is inhibited.

For example, when the operating current of the relay 3 is 10 mA, the current as for portion without the relay 3 is 150 mA, the power-supply source voltage of low voltage is 13 V, and the power-supply source voltage of high voltage is 17 V, in a conventional circuit (in which the relay 3 is operated when the voltage is high), power consumption of low voltage is 13 V x 0.15 A = 1.95 W while power consumption of high voltage is 17 V x (0.15 + 0.01) A = 2.72 W. On the other hand, in a circuit of the present invention, power consumption of low voltage is 13 V x (0.15 + 0.01) A = 2.08 W, while power consumption of high voltage is 17 V x 0.15 A = 2.55 W.

The largest power consumption of each case : the conventional circuit - - - 2.72 W ; the present embodiment - - - 2.55 W. As power consumption reflects calorific power, the present invention consumes less electric power, thus causes less calorific power.

In the present embodiment, an inverter 5 is used, but instead of an inverter, it is also possible to invert the polarities of the input side of the comparator 2.

As described above, according to the present invention, a relay is operated when a power-supply source voltage is low. Therefore, a useful 2-band LNB is provided in which power consumption is reduced and at the same timereduces calorific power inside the LNB.

### Claims

1. A low noise converter for receiving a plurality of frequency bands and having switch means (3) for switching between said bands in accordance with the level of a power supply voltage fed through an IF output terminal (1), wherein said switch means when energised consumes power derived from said power supply voltage, and wherein control means (R1, R2, 2, 5, TR) is provided for controlling the energisation of said switch means in accordance with said power supply voltage level, characterised in that said control means is so arranged that said switch means is energised when the power supply voltage is below a reference voltage level.

2. The low noise converter according to claim 1, wherein said control means comprises a comparator (2) and an inverter (5) which inverts polarities of output of said comparator.

3. The low noise converter according to claim 1, wherein said control means comprises a comparator (2) at an input side of which polarities of input are inverted.

4. The low noise converter according to claim 1, wherein said switch means is a relay (3).

5. The low noise converter according to claim 1, wherein said control means comprises a comparator (2), and an inverter (5) which inverts polarities of output of said comparator, and wherein said switch means is a relay (3).

6. The low noise converter according to claim 1, wherein said control means comprises a comparator (2) at an input side of which polarities of input are inverted and wherein said switch means is a relay (3).

## Patentansprüche

1. Ein rauscharmer Umsetzer zum Empfangen mehrerer Frequenzbänder und mit einer Schalteinrichtung (3) zum Schalten zwischen diesen Bändern in Übereinstimmung mit dem Pegel einer durch einen ZF-Ausgangsanschluß (1) angelegten Speisespannung, wobei die Schalteinrichtung, wenn sie erregt ist, von der Speisespannung abgeleitete Leistung aufnimmt, und wobei eine Steuereinrichtung (R1, R2, 2, 5, TR) zur Steuerung des Erregens der Schalteinrichtung in Übereinstimmung mit dem Speisespannungspegel vorgesehen ist, dadurch gekennzeichnet, daß die Steuereinrichtung so ausgebildet ist, daß die Schalteinrichtung erregt wird, wenn die Speisespannung unterhalb eines Referenzspannungspegels ist.

2. Der rauscharme Umsetzer nach Anspruch 1, in welchem die Steuereinrichtung einen Komparator (2) und einen Inverter (5) umfaßt, der Polaritäten von Ausgangssignalen des Komparators invertiert.

3. Der rauscharme Umsetzer nach Anspruch 1, in welchem die Steuereinrichtung einen Komparator (2) mit einer Eingangsseite umfaßt, an der Polaritäten von Eingangssignalen invertiert werden.

4. Der rauscharme Umsetzer nach Anspruch 1, in welchem die Schalteinrichtung ein Relais (3) ist.

5. Der rauscharme Umsetzer nach Anspruch 1, in welchem die Steuereinrichtung einen Komparator (2) und einen Inverter (5) umfaßt, der Polaritäten von Ausgangssignalen des Komparators invertiert, und in welchem die Schalteinrichtung ein Relais (3) ist.

6. Der rauscharme Umsetzer nach Anspruch 1, in welchem die Steuereinrichtung einen Komparator (2) mit einer Eingangsseite umfaßt, an der Polaritäten von Eingangssignalen invertiert werden, und in welchem die Schalteinrichtung ein Relais (3) ist.

## Revendications

1. Convertisseur à faible bruit pour recevoir une pluralité de bandes de fréquences, et ayant des moyens de commutation (3) pour effectuer la commutation entre lesdites bandes, en fonction du niveau d'une tension d'alimentation transmise par l'intermédiaire d'une terminaison de sortie IF (1), dans lequel lesdits moyens de commutation, lorsqu'ils sont alimentés en énergie, consomment de l'énergie dérivée de ladite tension d'alimentation, et dans lequel lesdits moyens de commande (R1, R2, 2, 5, TR) sont fournis pour commander l'alimentation en énergie desdits moyens de commutation, en fonction dudit niveau de tension d'alimentation, caractérisé en ce que lesdits moyens de commande sont conçus de telle sorte que lesdits moyens de commutation sont alimentés en énergie lorsque la tension d'alimentation est inférieure à un niveau de tension de référence.

2. Convertisseur à faible bruit selon la revendication 1, dans lequel lesdits moyens de commande comprennent un comparateur (2) et un inverseur (5) qui inverse les polarités de sortie dudit comparateur.

3. Convertisseur à faible bruit selon la revendication 1, dans lequel lesdits moyens de commande comprennent un comparateur (2) du côté d'une entrée, dont les polarités d'entrée sont inversées.

4. Convertisseur à faible bruit selon la revendication 1, dans lequel lesdits moyens de commutation sont un relais (3).

5. Convertisseur à faible bruit selon la revendication 1, dans lequel lesdits moyens de commande comprennent un comparateur (2), et un inverseur (5) qui inverse les polarités de sortie dudit comparateur, et dans lequel lesdits moyens de commutation sont un relais (3).

6. Convertisseur à faible bruit selon la revendication 1, dans lequel lesdits moyens de commande comprennent un comparateur (2) du côté d'une entrée, dont les polarités d'entrée sont inversées, et dans lequel lesdits moyens de commutation sont un relais (3).

C ─┤├─ ◎ ─I   IF Output Terminal

L

4   to each circuit

3 Relay   D

R3

R1

R4

R2   TR

2
Comparator   5 Inverter

Reference Voltage

FIG. 1

C ─┤├─ ◎ ─I

L

4   to each circuit

3   D

R3

R1   R4

R2   TR

2

Reference Voltage

FIG. 2